(19) Europäisches Patentamt
European Patent Office
Office européen des brevets

(11) **EP 2 824 470 B1**

(12) **FASCICULE DE BREVET EUROPEEN**

(45) Date de publication et mention de la délivrance du brevet:
**21.11.2018 Bulletin 2018/47**

(51) Int Cl.:
*G01R 33/24* *(2006.01)*  *G01R 33/26* *(2006.01)*
*G01R 33/04* *(2006.01)*

(21) Numéro de dépôt: **14175530.6**

(22) Date de dépôt: **03.07.2014**

(54) **Procédé et dispositif de mesure d'un champ magnétique au moyen d'excitations synchronisées**

Messverfahren und -vorrichtung zur Messung eines Magnetfelds mittels synchronisierter Anregungen

Method and device for measuring a magnetic field by means of synchronised excitations

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **08.07.2013 FR 1356704**

(43) Date de publication de la demande:
**14.01.2015 Bulletin 2015/03**

(73) Titulaire: **Commissariat à l'énergie atomique et aux énergies alternatives 75015 Paris (FR)**

(72) Inventeurs:
• **Le Prado, Matthieu**
  **38160 SAINT MARCELLIN (FR)**
• **Bertrand, François**
  **38700 LA TRONCHE (FR)**
• **Corsi, Marie-Constance**
  **38000 GRENOBLE (FR)**
• **Delevoye, Elisabeth**
  **38120 SAINT EGREVE (FR)**
• **Morales, Sophie**
  **38760 VARCES (FR)**

(74) Mandataire: **Brevalex**
  **95, rue d'Amsterdam**
  **75378 Paris Cedex 8 (FR)**

(56) Documents cités:
**US-A1- 2013 150 702**

• **JAMES E LENZ: "Magnetic Sensors", SCIENTIFIC HONEYWELLER,, vol. 6, no. 1, 1 avril 1985 (1985-04-01), pages 16-25, XP001425001,**
• **JEN-TZONG JENG ET AL: "Enhancement in Sensitivity Using Multiple null Harmonics for Miniature Fluxgates", IEEE TRANSACTIONS ON MAGNETICS, IEEE SERVICE CENTER, NEW YORK, NY, US, vol. 48, no. 11, 1 novembre 2012 (2012-11-01), pages 3696-3699, XP011468925, ISSN: 0018-9464, DOI: 10.1109/TMAG.2012.2204237**
• **CRUZ J C ET AL: "Design of a fourth harmonic fluxgate magnetometer", SENSORS AND ACTUATORS A, ELSEVIER SEQUOIA S.A., LAUSANNE, CH, vol. 78, no. 2-3, 14 décembre 1999 (1999-12-14), pages 71-73, XP004252953, ISSN: 0924-4247, DOI: 10.1016/S0924-4247(99)00194-6**
• **KIM H C ET AL: "A NEW METHOD FOR FLUXGATE MAGNETOMETERS USING THE COUPLING PROPERTY OF ODD AND EVEN HARMONICS", MEASUREMENT SCIENCE AND TECHNOLOGY, IOP, BRISTOL, GB, vol. 6, no. 7, 1 juillet 1995 (1995-07-01), pages 898-903, XP000521534, ISSN: 0957-0233, DOI: 10.1088/0957-0233/6/7/007**
• **PRIMDAHL F: "The fluxgate magnetometer", JOURNAL OF PHYSICS E. SCIENTIFIC INSTRUMENTS, IOP PUBLISHING, BRISTOL, GB, vol. 12, no. 4, 1 avril 1979 (1979-04-01), pages 241-253, XP001423559, ISSN: 0022-3735**
• **J. DUPONT-ROC: "Étude théorique de diverses résonances observables en champ nul sur des atomes <<habillés>> par des photons de radiofréquence", JOURNAL DE PHYSIQUE, vol. 32, no. 2-3, 1 février 1971 (1971-02-01), pages 135-144, XP055105763, ISSN: 0302-0738, DOI: 10.1051/jphys:01971003202-3013500**

EP 2 824 470 B1

**Description**

**DOMAINE TECHNIQUE**

Le domaine de l'invention est celui des magnétomètres pour lesquels la mesure d'un champ magnétique comprend la mesure de l'amplitude d'un signal à un harmonique d'une fréquence d'oscillation d'une source d'excitation. L'invention s'étend plus particulièrement aux magnétomètres à noyau saturé ainsi qu'aux magnétomètres atomiques à résonances paramétriques en champ nul.

**ÉTAT DE LA TECHNIQUE ANTÉRIEURE**

On connaît des magnétomètres dont le principe de mesure est basé sur l'utilisation d'un harmonique parmi plusieurs générés au moyen d'une source d'excitation (voir par exemple l'article de Lenz J.E., "Magnetic sensors", Scientific Honeyweller, vol. 6(1), 1985).

C'est le cas par exemple des magnétomètres de type à noyau saturé (également connus sous le terme « fluxgate ») dans lesquels un courant d'excitation alternatif est appliqué à une bobine d'excitation entourant un noyau magnétique. Le champ magnétique à mesurer induit des pulsations de courant dans une bobine de détection qui entoure également le noyau magnétique, lesdites pulsations présentant des résonances à des harmoniques de la fréquence du courant d'excitation. L'amplitude des harmoniques paires est proportionnelle au champ à mesurer.

C'est également le cas des magnétomètres atomiques à résonances paramétriques en champ nul. Ces magnétomètres emploient une cellule remplie d'un gaz d'atomes, une source laser qui émet un faisceau polarisé en direction de la cellule selon une direction de propagation, ainsi qu'un photodétecteur apte à délivrer un signal de sortie représentatif du faisceau ayant traversé la cellule. Une bobine entoure la cellule, alimentée par un générateur de fréquence pour générer un champ magnétique d'excitation sinusoïdal, perpendiculaire à ladite direction de propagation et parallèle au champ à mesurer.

On pourra trouver une présentation du principe de fonctionnement de tels magnétomètres atomiques dans l'article de J. Dupont-Roc, intitulé «Etude théorique de diverses résonances observables en champ nul sur des atomes "habillés" par des photons de radiofréquence», Le journal de physique, Tome 32, février 1971, p135.

Le signal S capté par le photodétecteur comprend plusieurs harmoniques dont les expressions sont les suivantes.

$$S = J_0 M + \sum_{q \geq 1}(2J_{2q}\cos 2q\omega t).M - \sum_{q \geq 0}(2J_{2q+1}\cos(2q+1)\omega t).N \text{ ,}$$

où

$$M = \frac{\lambda J_0}{\Gamma}\frac{\Gamma^2 + {\omega_x}^2}{\Gamma^2 + {\omega_x}^2 + {\omega_y}^2 + {\omega_z}^2},$$

$$N = \frac{\lambda J_0}{\Gamma}\frac{\Gamma\omega_z + \omega_x\omega_y}{\Gamma^2 + {\omega_x}^2 + {\omega_y}^2 + {\omega_z}^2},$$

$\omega_i$ est le champ magnétique sur l'axe i, multiplié par $\gamma$ le rapport gyromagnétique du niveau d'énergie considéré pour l'atome,
$\lambda$ décrit l'orientation induite par le pompage optique,
$1/\Gamma$ est le temps de relaxation du niveau d'énergie considéré pour l'atome,

$J_n$ est la fonction de Bessel d'ordre n et d'argument $\dfrac{\gamma B_1}{\omega}$.

S contient plus particulièrement des résonances impaires aux fréquences $\dfrac{(2q+1)\omega}{2\pi}$ (avec q un entier positif ou nul) qui sont proportionnelles au champ magnétique à mesurer sur l'axe z.

Seule la résonance à la fréquence du champ d'excitation ω/2π est en réalité traitée, les autres harmoniques n'étant pas utilisés. Cette résonance est présente en champ magnétique faible $\omega_i < \Gamma$, où $i \in \{x, y, z\}$. Elle permet de mesurer un champ magnétique faible soit en connaissant la pente de la résonance autour de Bz =0, soit via l'asservissement d'un champ magnétique de compensation Bc dont l'amplitude est ajustée afin que la somme Bc + Bz soit maintenue à zéro en permanence. De cette manière, la connaissance du courant Ic injecté dans la bobine pour appliquer le champ de compensation permet de connaître Bz puisque Bc = -Bz.

Les méthodes de pompage optique et de détection des lasers peuvent être ajustées (par exemple par la pression des gaz qui composent la cellule) afin de réduire le bruit du magnétomètre : on cherche d'une manière générale à toujours plus accroitre la sensibilité de la mesure et à viser un meilleur ratio signal à bruit.

## EXPOSÉ DE L'INVENTION

L'invention a pour objectif de répondre à cette demande, et propose pour ce faire un dispositif de mesure d'un champ magnétique tel que défini dans la revendication 1.

Certains aspects préférés mais non limitatifs de ce dispositif sont définis dans les revendications 2 à 7.

Selon un autre aspect, l'invention concerne un procédé de mesure d'un champ magnétique tel que défini dans la revendication 8.

## BRÈVE DESCRIPTION DES DESSINS

D'autres aspects, buts, avantages et caractéristiques de l'invention apparaîtront mieux à la lecture de la description détaillée suivante de formes de réalisation préférées de celle-ci, donnée à titre d'exemple non limitatif, et faite en référence aux dessins annexés sur lesquels :

- la figure 1 est un schéma illustrant l'amplitude des harmoniques proportionnels au champ magnétique à mesurer résultant d'une excitation conventionnelle ;
- la figure 2 est un schéma illustrant l'amplitude des harmoniques proportionnels au champ magnétique à mesurer résultant d'une excitation conforme à l'invention ;
- la figure 3 est un schéma d'un magnétomètre atomique à résonances paramétriques en champ nul conforme à un mode de réalisation possible de l'invention.

## EXPOSÉ DÉTAILLÉ DE MODES DE RÉALISATION PARTICULIERS

L'invention concerne selon un premier aspect un dispositif de mesure d'un champ magnétique, comportant un détecteur configuré pour mesurer l'amplitude d'un signal de sortie à un harmonique d'une fréquence d'oscillation d'une source d'excitation, ladite amplitude étant proportionnelle au champ magnétique à mesurer.

Dans un premier mode de réalisation, le dispositif est un magnétomètre atomique à résonances paramétriques en champ nul, comportant :

- une cellule remplie d'un gaz ;
- une source laser apte à émettre un faisceau de pompage optique polarisé en direction de la cellule selon une direction de propagation ;
- une bobine entourant la cellule et un générateur de fréquence alimentant la bobine, la bobine et le générateur formant un circuit d'excitation,
- un photodétecteur apte à délivrer un signal représentatif du faisceau ayant traversé la cellule formant ledit signal de sortie.

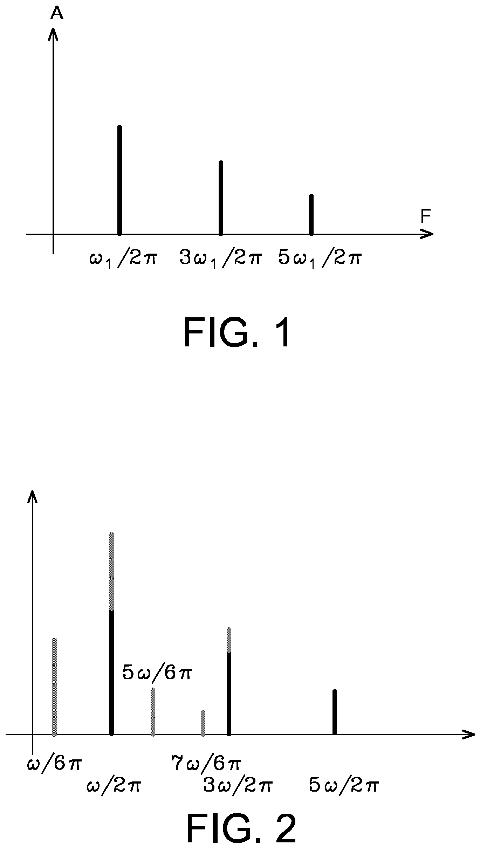

Selon une excitation conventionnelle, le générateur de fréquence alimente la bobine pour générer un champ magnétique d'excitation sinusoïdal B1cosω1t perpendiculaire à ladite direction de propagation si le laser est en polarisation circulaire, ou perpendiculaire à la polarisation si le laser est polarisé rectilignement. Comme illustré par la figure 1, le signal capté par le photodétecteur présente une résonance aux harmoniques de la fréquence du champ magnétique d'excitation, l'amplitude A de la résonance aux harmoniques impairs ω1/2π, 3ω1/2π, 5ω1/2π, etc. étant proportionnelle au champ magnétique à mesurer. Comme également illustré par la figure 1, les amplitudes maximales des résonances impaires aux fréquences $\dfrac{(2q+1)\omega_1 t}{2\pi}$ décroissent à mesure que l'ordre (2q+1) des harmoniques, q étant un entier, augmente.

Afin d'augmenter l'énergie du signal, il pourrait être envisagé d'exploiter plusieurs des harmoniques impairs.

Il en résulterait toutefois une augmentation concomitante du niveau de bruit.

L'invention propose une approche différente qui consiste en ce que le circuit d'excitation soit configuré pour associer à une source d'excitation principale oscillant à une fréquence d'oscillation principale au moins une source d'excitation secondaire oscillant à une fréquence d'oscillation secondaire qui est une fraction de la fréquence d'oscillation principale, ladite fraction étant impaire, respectivement paire, si ledit harmonique auquel l'amplitude proportionnelle au champ à mesurer est étudiée est impair, respectivement pair.

Revenant à l'exemple du magnétomètre atomique, le générateur de fréquence est ainsi configuré pour alimenter la bobine de manière à générer une combinaison de champs magnétiques d'excitation colinéaires $\Sigma B_i cos\omega_i t$, dont les fréquences $\omega_i/2\pi$ sont des sous-multiples impairs d'une fréquence de référence. On vient ainsi superposer plusieurs signaux à une seule fréquence sans augmenter l'énergie du bruit.

La figure 2 est un schéma illustrant l'amplitude des harmoniques proportionnels au champ magnétique à mesurer résultant d'une excitation conforme à l'invention avec un champ magnétique d'excitation principal $B_1 cos\omega_1 t$ et un champ magnétique d'excitation secondaire $B_2 cos(\omega_2 t+ \varphi_2)$, avec $\omega_2 = \omega_1/3$.

L'amplitude des résonances du signal capté par le photodétecteur aux harmoniques impairs de la fréquence principale et de la fréquence secondaire sont proportionnelles au champ magnétique à mesurer. Ainsi notamment, deux pics se superposent à $\omega_1/2\pi = 3\omega_2/2\pi$ qui consistent en l'amplitude A de la résonance du signal à l'harmonique fondamental (ordre 1) de la fréquence d'oscillation principale et en l'amplitude de la résonance du signal à l'harmonique d'ordre 3 de la fréquence d'oscillation secondaire. Cette superposition se traduit par une augmentation du niveau du signal et donc du rapport signal à bruit.

Afin de maximiser l'amplitude des 2 résonances observées à $\omega_1/2\pi$, il faut trouver le jeu de paramètres impactant, i.e. $\{\dfrac{\gamma B_1}{\omega 1} ; \dfrac{\gamma B_2}{\omega 1/3}\}$ qui optimise l'amplitude de la résonance à la fréquence $\omega_1/2\pi$.

Dans un mode de réalisation, on ajoute également d'autres excitations secondaires à des fréquences secondaires $\omega_3 = \omega_1/5$, $\omega_4 = \omega_1/7$, etc., afin de bénéficier de la contribution de leurs harmoniques d'ordre 5, 7, etc. Ces contributions sont toutefois de plus en plus faibles à mesure que l'ordre à considérer pour une contribution à $\omega_1/2\pi$ augmente.

Empiriquement, afin de limiter le temps de recherche des optimums de fonctionnement, on peut tout d'abord appliquer l'excitation principale (celle dont la fréquence est la plus haute) $B_1 cos\omega_1 t$ dont on ajuste le ratio $\dfrac{\gamma B_1}{\omega_1}$ (autour de 1), en fonction d'un maximum de $S\omega_1$ (composante du signal S à la pulsation $\omega_1$). On applique ensuite l'excitation secondaire dont on ajuste la fréquence pour obtenir un pic de résonance à son harmonique d'ordre 3 (ou 5, 7, etc. le cas échéant) légèrement décalé du pic de résonance de l'harmonique fondamental de l'excitation principale. On ajuste alors le ratio $\dfrac{\gamma B_2}{\omega_2}$. On vient ensuite caler précisément la fréquence de l'excitation secondaire pour obtenir une superposition des pics de résonance et on ajuste alors la phase $\varphi_2$. L'application de l'excitation secondaire va légèrement modifier le réglage optimal de $\dfrac{\gamma B_1}{\omega_1}$ qui peut alors être repris. Et on procède ainsi de suite pour l'ajout de modulations secondaires supplémentaires basses fréquences.

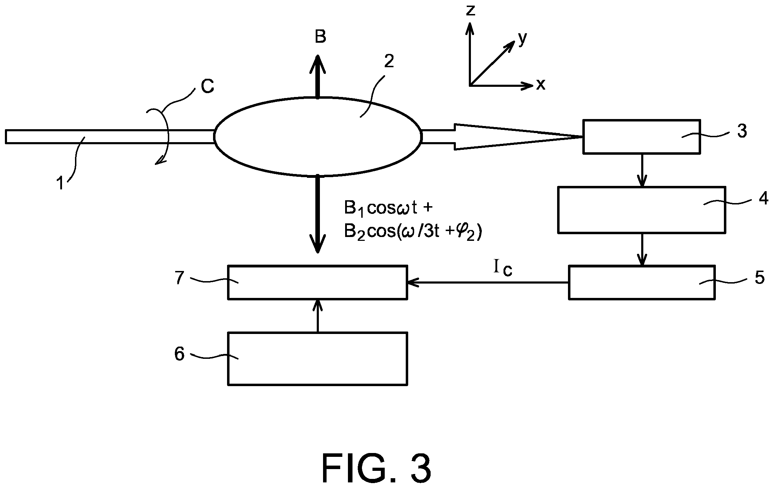

On a représenté sur la figure 3 un exemple de réalisation d'un dispositif selon ce mode de réalisation possible de l'invention. Le dispositif comprend un laser émettant un faisceau 1 à une longueur d'onde de 1083 nm, un polariseur circulaire C délivrant un faisceau polarisé circulairement, une cellule 2 de 5 cm$^3$ remplie d'hélium 4 sous une pression de 100 mPa, un photodétecteur 3 recevant le faisceau ayant traversé la cellule 2, un détecteur synchrone 4 réglé à $\omega/2\pi$ et fournissant le module du champ B à mesurer. Le dispositif comporte un circuit d'asservissement 5 délivrant un courant Ic qui est injecté dans des bobines de Helmholtz 7 afin de générer un champ magnétique de compensation Bc tel que la somme Bc + B est maintenue à zéro en permanence. Il comporte par ailleurs un générateur de fréquence 6 qui alimente les bobines 7 afin de générer le champ magnétique d'excitation $B_1 cos\omega t + B_2 cos(\omega/3t+ \varphi_2)$ résultant de la combinaison d'un champ magnétique d'excitation principal sinusoïdal à $\omega/2\pi$ et d'un champ magnétique d'excitation secondaire sinusoïdal, ici à $\omega/6\pi$ et décalé en phase de $\varphi_2$. Un circuit de décharge RF permet par ailleurs de réaliser une décharge électrostatique haute fréquence entre deux électrodes placées dans la cellule 2.

Un exemple de réalisation consiste par exemple à adopter les réglages suivants pour la cellule de gaz d'hélium

$\dfrac{\gamma B_1}{\omega_1} = 1$ et $\dfrac{\gamma B_2}{\omega 1/3} = 4$ ($\gamma/2\pi$ = 28 Hz/nT pour l'hélium 4).

On choisit $\omega/2\pi$ = 40 kHz (les fréquences des champs d'excitation devant être supérieures à la fréquence de relaxation du niveau d'énergie sensible magnétiquement) et B1 = 1400 nT et B2 = 1900 nT.

Le circuit de décharge RF est par exemple contrôlé pour appliquer un champ électrique à 10 MHz, 50 mW à l'hélium 4 via les deux électrodes afin de peupler le niveau d'énergie sensible magnétiquement.

L'ajout de l'excitation secondaire à une fréquence $\omega/6\pi$, 3 fois plus faible, permet de doubler l'amplitude A de la résonance à la fréquence $\omega/2\pi$. Cela se traduit directement par un bruit en unité de champ magnétique $(T/\sqrt{Hz})$ divisé par 2 pour le magnétomètre.

Dans un second mode de réalisation, le dispositif est un magnétomètre du type magnétomètre à noyau saturé, dans lequel le circuit d'excitation est configuré pour associer des courants d'excitation alternatifs fournis à une bobine d'excitation entourant un noyau magnétique, à savoir un courant d'excitation principal à une fréquence d'oscillation principale et au moins un courant d'excitation secondaire à une fréquence d'oscillation secondaire qui est une fraction paire de la fréquence d'oscillation principale. Dans le cadre de ce mode de réalisation, on cherche à superposer des pics au niveau de l'harmonique d'ordre 2 ou d'ordre 4 de la fréquence d'oscillation principale.

L'invention n'est par ailleurs par limitée au dispositif selon son premier aspect, mais s'étend également à un procédé de mesure d'un champ magnétique mettant en oeuvre une mesure de l'amplitude d'un signal à un harmonique d'une fréquence d'oscillation d'une source d'excitation, ladite amplitude étant proportionnelle au champ magnétique à mesurer, caractérisé par l'association d'une source d'excitation principale oscillant à une fréquence d'oscillation principale et d'au moins une source d'excitation secondaire oscillant à une fréquence d'oscillation secondaire qui est une fraction de la fréquence d'oscillation principale, ladite fraction étant impaire, respectivement paire, si ledit harmonique est impair, respectivement pair.

On retiendra que l'invention s'avère pertinente dans les applications qui requièrent une excellente sensibilité, comme c'est le cas notamment des applications médicales, telles que la magnétocardiographie ou la magnétoencéphalographie.

## Revendications

**1.** Dispositif de mesure d'un champ magnétique, comportant un détecteur (4) configuré pour mesurer l'amplitude A d'un signal de sortie à un harmonique d'une fréquence d'oscillation principale d'un générateur de fréquence (6), ladite amplitude étant proportionnelle au champ magnétique à mesurer (B), **caractérisé en ce qu'**il comporte un circuit d'excitation (6, 7) configuré pour associer des champs magnétiques comprenant un champ magnétique d'excitation principal sinusoïdal et au moins un champ magnétique d'excitation secondaire sinusoïdal, le champ magnétique d'excitation principal sinusoïdal étant généré à l'aide d'une source d'excitation principale comprise dans le générateur de fréquence (6) oscillant à ladite fréquence d'oscillation principale, et le champ magnétique d'excitation secondaire sinusoïdal étant généré à l'aide d'une source d'excitation secondaire comprise dans le générateur de fréquence (6) oscillant à une fréquence d'oscillation secondaire qui est une fraction de la fréquence d'oscillation principale, ladite fraction étant de la forme 1/n où n est un entier impair, respectivement pair, si ledit harmonique est impair, respectivement pair.

**2.** Dispositif selon la revendication 1, ledit dispositif étant du type magnétomètre atomique à résonances paramétriques en champ nul, comportant :

   - une cellule (2) remplie d'un gaz ;
   - une source laser apte à émettre un faisceau de pompage optique (1) polarisé en direction de la cellule selon une direction de propagation ;
   - une bobine (7) entourant la cellule et un générateur de fréquence (6) alimentant la bobine, la bobine et le générateur formant ledit circuit d'excitation, et
   - un photodétecteur (3) apte à délivrer audit détecteur (4) un signal représentatif du faisceau ayant traversé la cellule formant ledit signal de sortie,

dans lequel le circuit d'excitation (6, 7) est configuré de telle sorte que n est un entier impair.

**3.** Dispositif selon la revendication 2, dans lequel ledit harmonique est le fondamental de la fréquence d'oscillation principale.

**4.** Dispositif selon l'une des revendications 2 et 3, comprenant en outre un circuit d'asservissement (5) configuré pour injecter un courant (Ic) dans la bobine (7) afin de générer un champ magnétique de compensation à somme nulle avec le champ magnétique à mesurer.

**5.** Dispositif selon l'une des revendications 2 à 4, dans lequel le détecteur est un détecteur synchrone calé audit harmonique.

**6.** Dispositif selon la revendication 1, ledit dispositif étant du type magnétomètre à noyau saturé, dans lequel le circuit d'excitation est configuré pour associer des courants d'excitation alternatifs fournis par les sources d'excitation principale et secondaire à une bobine d'excitation entourant un noyau magnétique, et dans lequel le circuit d'excitation est configuré de telle sorte que n est un entier pair.

**7.** Dispositif selon la revendication 6, dans lequel ledit harmonique est l'harmonique d'ordre 2 ou d'ordre 4 de la fréquence d'oscillation principale.

**8.** Procédé de mesure d'un champ magnétique mettant en oeuvre une mesure de l'amplitude A d'un signal à un harmonique d'une fréquence d'oscillation principale d'un générateur de fréquence (6), ladite amplitude étant proportionnelle au champ magnétique à mesurer (B), **caractérisé par** l'association de champs magnétiques comprenant un champ magnétique d'excitation principal sinusoïdal et au moins un champ magnétique d'excitation secondaire sinusoïdal, le champ magnétique d'excitation principal sinusoïdal étant généré à l'aide d'une source d'excitation principale comprise dans le générateur de fréquence (6) oscillant à ladite fréquence d'oscillation principale et le champ magnétique d'excitation secondaire sinusoïdal étant généré à l'aide d'une source d'excitation secondaire comprise dans le générateur de fréquence (6) oscillant à une fréquence d'oscillation secondaire qui est une fraction de la fréquence d'oscillation principale, ladite fraction étant de la forme 1/n où n est un entier impair, respectivement pair, si ledit harmonique est impair, respectivement pair.

**Patentansprüche**

**1.** Vorrichtung zum Messen eines Magnetfeldes, aufweisend einen Detektor (4), der konfiguriert ist, um die Amplitude A eines Ausgangssignals bei einer Harmonischen einer Hauptschwingungsfrequenz eines Frequenzgenerators (6) zu messen, wobei die Amplitude proportional zu dem zu messenden Magnetfeld (B) ist, **dadurch gekennzeichnet, dass** sie einen Erregerkreis (6, 7) aufweist, der konfiguriert ist, Magnetfelder zu assoziieren, die ein sinusförmiges Haupterregermagnetfeld und mindestens ein sinusförmiges Sekundär-Erregermagnetfeld beinhalten, wobei das sinusförmige Haupterregermagnetfeld mit Hilfe einer Haupterregerquelle erzeugt wird, die in dem Frequenzgenerator (6) enthalten ist, der auf der Hauptschwingungsfrequenz schwingt, und das sinusförmige Sekundär-Erregermagnetfeld mit Hilfe einer Sekundär-Erregerquelle erzeugt wird, die in dem Frequenzgenerator (6) enthalten ist, der auf einer Sekundär-Schwingungsfrequenz schwingt, bei der es sich um einen Bruchteil der Hauptschwingungsfrequenz handelt, wobei der Bruchteil die Form 1/n hat, und n eine ungeradzahlige, bzw. geradzahlige, Ganzzahl ist, wenn die Harmonische ungeradzahlig, bzw. geradzahlig, ist.

**2.** Vorrichtung nach Anspruch 1, wobei die Vorrichtung vom Typ eines Parameterresonanz-Atommagnetometers im Nullfeld ist, aufweisend:

eine Zelle (2), die mit Gas gefüllt ist;
eine Laserquelle, die geeignet ist, einen optischen Pumpstrahl (1) auszusenden, der in Richtung der Zelle gemäß einer Ausbreitungsrichtung polarisiert ist;
eine Spule (7), welche die Zelle umgibt, und einen Frequenzgenerator (6), der die Spule versorgt, wobei die Spule und der Generator den Erregerkreis bilden, und
einen Photodetektor (3), der geeignet ist, an den Detektor (4) ein Signal zu liefern, welches für den Strahl repräsentativ ist, der die Zelle durchquert hat, und welches das Ausgangssignal bildet,
wobei der Erregerkreis (6, 7) derart konfiguriert ist, dass n eine ungeradzahlige Ganzzahl ist.

**3.** Vorrichtung nach Anspruch 2, wobei die Harmonische die Grundschwingung der Hauptschwingungsfrequenz ist.

**4.** Vorrichtung nach einem der Ansprüche 2 und 3, weiter aufweisend eine Regelungsschaltung (5), die konfiguriert ist, um einen Strom (Ic) in die Spule (7) einzubringen, um dadurch ein Kompensationsmagnetfeld zu erzeugen, das mit dem zu messenden Magnetfeld eine Nullsumme bildet.

**5.** Vorrichtung nach einem der Ansprüche 2 bis 4, wobei der Detektor ein Synchrondetektor ist, der auf die Harmonische eingerichtet ist.

**6.** Vorrichtung nach Anspruch 1, wobei die Vorrichtung vom Typ eines Saturationskern-Magnetometers ist, wobei der Erregerkreis konfiguriert ist, um Erregerwechselströme, die durch die Haupt- und Sekundär-Erregerquellen geliefert werden, einer Erregerspule zuzuführen, die einen Magnetkern umgibt, und wobei der Erregerkreis derart konfiguriert ist, dass n eine geradzahlige Ganzzahl ist.

**7.** Vorrichtung nach Anspruch 6, wobei die Harmonische eine Harmonische zweiter oder vierter Ordnung der Hauptschwingungsfrequenz ist.

**8.** Verfahren zum Messen eines Magnetfeldes, bei dem eine Messung der Amplitude A eines Signals einer Harmonischen einer Hauptschwingungsfrequenz eines Frequenzgenerators (6) durchgeführt wird, wobei die Amplitude zu dem zu messenden Magnetfeld (B) proportional ist, **gekennzeichnet durch** das Assoziieren von Magnetfeldern, die ein sinusförmiges Haupterregermagnetfeld und mindestens ein sinusförmiges Sekundär-Erregermagnetfeld beinhalten, wobei das sinusförmige Haupterregermagnetfeld mit Hilfe einer Haupterregerquelle erzeugt wird, die in dem Frequenzgenerator (6) enthalten ist, der auf der Hauptschwingungsfrequenz schwingt, und das sinusförmige Sekundär-Erregermagnetfeld mit Hilfe einer Sekundär-Erregerquelle erzeugt wird, die in dem Frequenzgenerator (6) enthalten ist, der auf einer Sekundär-Schwingungsfrequenz schwingt, bei der es sich um einen Bruchteil der Hauptschwingungsfrequenz handelt, wobei der Bruchteil die Form 1/n hat, und n eine ungeradzahlige, bzw. geradzahlige, Ganzzahl ist, wenn die Harmonische ungeradzahlig, bzw. geradzahlig, ist.

**Claims**

**1.** Magnetic field measurement device, comprising a detector (4) configured to measure the amplitude A of an output signal at a harmonic of a principal oscillation frequency of a frequency generator (6), said amplitude being proportional to the magnetic field (B) to be measured, **characterised in that** it comprises an excitation circuit (6, 7) configured to associate magnetic fields comprising a principal sinusoidal excitation magnetic field and at least one secondary sinusoidal excitation magnetic field, the principal sinusoidal excitation magnetic field being generated by a principal excitation source comprised in said frequency generator (6) oscillating at said principal oscillation frequency, and the secondary sinusoidal excitation magnetic field being generated by a secondary excitation source comprised in said frequency generator (6) oscillating at a secondary oscillation frequency that is a fraction of the principal oscillation frequency, said fraction being of the form 1/n where n is an integer which is odd, respectively even, if said harmonic is odd, respectively even.

**2.** Device according to claim 1, said device being a zero-field parametric resonance atomic magnetometer, comprising:

- a cell (2) filled with a gas;
- a laser source capable of emitting a polarised optical pumping beam (1) in the direction of the cell along a propagation direction;
- a coil (7) surrounding the cell and a frequency generator (6) powering the coil, the coil and the generator forming said excitation circuit, and
- a photodetector (3) capable of outputting to the detector (4) a signal representative of the beam that passed through the cell forming said output signal,

wherein the excitation circuit (6, 7) is configured so that n is an odd integer.

**3.** Device according to claim 2, in which said harmonic is the fundamental of the principal oscillation frequency.

**4.** Device according to either claim 2 or claim 3, further comprising a servoing circuit (5) configured to inject a current (Ic) into the coil (7) so as to generate a compensating magnetic field creating a zero sum with the magnetic field to be measured.

**5.** Device according to any one of claims 2 to 4, in which the detector is a synchronous detector tuned to said harmonic.

**6.** Device according to claim 1, said device being a saturated core magnetometer, in which the excitation circuit is configured to associate alternating excitation currents output by the main and secondary excitation sources to an excitation coil surrounding a magnetic core, and in which the excitation circuit (6, 7) is configured so that n is an even integer

7. Device according to claim 6, in which said harmonic is the order 2 or order 4 harmonic of the principal oscillation frequency.

8. Method of measuring a magnetic field making use of a measurement of the amplitude A of a signal at a harmonic of a principal oscillation frequency of a frequency generator, said amplitude being proportional to the magnetic field to be measured, **characterised by** the association of magnetic fields comprising a principal sinusoidal excitation magnetic field and at least one secondary sinusoidal excitation magnetic field, the principal sinusoidal excitation magnetic field being generated by a principal excitation source comprised in said frequency generator (6) oscillating at said principal oscillation frequency, and the secondary sinusoidal excitation magnetic field being generated by a secondary excitation source comprised in said frequency generator (6) oscillating at a secondary oscillation frequency that is a fraction of the principal oscillation frequency, said fraction being of the form 1/n where n is an integer which is odd, respectively even, if said harmonic is odd, respectively even.

FIG. 1

FIG. 2

FIG. 3

EP 2 824 470 B1

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

### Littérature non-brevet citée dans la description

- **LENZ J.E.** Magnetic sensors. *Scientific Honeyweller,* 1985, vol. 6 (1

- **J. DUPONT-ROC.** Etude théorique de diverses résonances observables en champ nul sur des atomes ''habillés'' par des photons de radiofréquence. *Le journal de physique,* Février 1971, vol. 32, 135